# FASCICULE DE BREVET EUROPEEN

(11) **EP 3 109 921 B1**
(45) Date de publication et mention de la délivrance du brevet: **11.04.2018**
(21) Numéro de dépôt: 16175629.1
(22) Date de dépôt: 22.06.2016
(51) Int. Cl.: H01M 2/02, H01M 10/052, H01M 10/0585, H01M 6/40, H01G 11/10, H01L 51/00, H01G 11/78, H01G 11/84

(54) **PROCÉDÉ DE FABRICATION D'UN DISPOSITIF ÉLECTRONIQUE**
HERSTELLUNGSVERFAHREN EINER ELEKTRONISCHEN VORRICHTUNG
MANUFACTURING PROCESS OF AN ELECTRONIC DEVICE

(30) Priorité: 26.06.2015 FR 1555937
(43) Date de publication de la demande: 28.12.2016
(73) Titulaire: COMMISSARIAT À L'ÉNERGIE ATOMIQUE ET AUX ÉNERGIES ALTERNATIVES, 75015 Paris (FR)
(72) Inventeur: BEDJAOUI, Messaoud, 38340 Voreppe (FR); GARREC, Pierre, 38410 Saint Martin d'Uriage (FR); NIZOU, Sylvain, 37530 Poce Sur Cisse (FR)
(74) Mandataire: Decobert, Jean-Pascal

(56) Documents cités:
- FR-A1- 2 771 852
- US-A1- 2006 081 978
- US-A1- 2009 075 428
- US-A1- 2010 239 907
- US-A1- 2011 159 638

## Description

### Domaine de l'invention

L'invention est relative à un procédé de fabrication d'un dispositif électronique comprenant un substrat.

Elle s'adresse préférentiellement à la réalisation des dispositifs microélectroniques tels que ceux sensibles notamment à l'air sur substrats fins et ultrafins préalablement fixés sur des porteurs épais. L'une des applications potentielles avantageuses de cette technique concerne les micro-batteries solides réalisées sur des substrats par exemple en verre fin et ultrafin. Plus précisément, suivant un mode de réalisation non limitatif, l'invention propose une technique de fabrication d'un système d'encapsulation performant tout en offrant une solution de séparation des batteries individuelles réalisées sur substrats fins et ultrafins. L'application aux batteries n'est pas limitative.

### Etat de la technique

Le développement et l'essor des systèmes intelligents embarqués, en anglais « smart systems », est conditionné par la levée d'un certain nombre de verrous technologiques. Outre les verrous liés aux matériaux actifs constituant les dispositifs microélectroniques et leurs procédés de mise en oeuvre et d'intégration, la problématique des substrats employés comme base de réalisation des organes microélectroniques est très déterminante pour ces applications. Ainsi, de nouveaux procédés préconisent l'emploi de substrats de plus en plus fins en vue de la réalisation de dispositifs microélectroniques répondant à des critères technologiques comme l'épaisseur réduite ou la flexibilité, et industriels comme le coût ou la disponibilité. Les principaux circuits concernés sont les dispositifs de stockage d'énergie comme les micro-batteries typiquement au lithium, les composants de l'électronique organique comme les diodes électroluminescentes organiques DELO ou OLED en anglais (Organic Light-Emitting Diodes), les cellules photovoltaïques organiques ou OPV en anglais (Organic PhotoVoltaic cells), les photodétecteurs organiques ou OPD en anglais (Organic PhotoDetectors) et les transistors de type TFT (Thin Film Transistor).

Dans la pratique, les substrats minces et ultraminces doivent être maniés avec une extrême précaution en raison de leur fragilité mécanique. En effet, la multiplication, l'enchainement et la complexité des étapes établies lors des procédés microélectroniques (telles que transfert, dépôt, gravure, nettoyage...) peuvent être destructrices pour des substrats fragiles. Cette difficulté technique a conduit à la mise au point de procédés industriels permettant une fixation temporaire des substrats fragiles sur des supports plus solides. Néanmoins, le recours aux procédés de fixation temporaire des substrats fins et ultrafins impose une étape de désolidarisation en fin de procédé de réalisation. Le procédé de séparation des deux substrats est assez souvent complexe, couteux et incompatible avec les dispositifs microélectroniques. A titre d'exemple, les solutions de collage temporaire des substrats par traitement de surface ou par emploi d'adhésifs sont incompatibles avec les dispositifs microélectroniques nécessitant des étapes technologiques réalisées à haute température. Ainsi, le document WO-A2-2013119737 propose une solution de collage localisé de substrats fragiles sur porte-substrats. Elle est basée sur la réalisation d'un traitement de surface adéquat permettant un collage de la partie sous-jacente des zones périphériques des composants. Ce procédé de collage est incompatible avec les technologies qui nécessitent le recours aux étapes thermiques (souvent à des températures supérieures 400°C). La découpe des substrats fragiles par détourage permet la libération des composants. La profondeur des traits de détourage réalisés doit être identique à l'épaisseur du substrat fragile limitant considérablement le choix de la technique de découpe. De plus, le support de substrat employé n'est pas réutilisable et l'opération de découpe nécessite la protection des couches actives en absence des couches d'encapsulation.

Un autre problème commun à certains circuits employés dans des composants microélectroniques tels que ceux cités plus haut (dont OLEDs, cellules capacitives ou autres) réside dans leur très forte sensibilité vis-à-vis des gaz oxydants. Cette sensibilité engendre l'emploi de systèmes d'encapsulation dont les performances requises varient d'une application à une autre. Ces performances sont fréquemment exprimées en termes de vitesses de transmission de la vapeur d'eau (WVTR pour Water Vapor Transmission Rate) ou encore en vitesse de transmission de l'oxygène (OTR pour Oxygen Transmission Rate). Concrètement, les niveaux de barrière WVTR et OTR exigés pour des applications comme les micro-batteries au lithium sont respectivement de l'ordre de 10⁻⁴ g/m²/j et de 10⁻⁴ cm³/m²/j. Bien que l'étanchéité obtenue soit en grande partie fonction du système d'encapsulation couvrant la face avant de ces composants, elle dépend également de la nature du substrat utilisé pour prévenir toute dégradation qui peut intervenir au niveau de la face arrière. D'une façon générale, une protection hermétique doit prendre en considération l'étanchéité des deux faces du composant en plus de la protection latérale. Ainsi, il est fortement recommandé d'employer des substrats avec des propriétés barrières à l'humidité et l'oxygène pour les applications sensibles. Les documents US2011/0159638 et US2009/0075428 concernent un procédé de fabrication de composants électroniques tels que des puces, dans lequel un substrat est solidarisé à un support et un film est formé sur l'autre face du substrat pour encapsuler les puces déposées sur le substrat, le substrat étant ensuite désolidarisé du support. D'une manière générale, la problématique de réalisation des dispositifs microélectroniques sur substrat fragile est partiellement résolue par l'emploi des systèmes convoyeurs agissant comme supports et permettant le déplacement et le maniement de ces substrats fragiles durant les étapes technologiques. Les mécanismes de ces systèmes sont basés sur des techniques de fixation très spécifiques comme le clampage électrostatique à électrode. Néanmoins, l'emploi des systèmes convoyeurs formés par la fixation des substrats fragiles sur des supports plus solides reste confronté aux difficultés de désolidarisation du substrat du support en fin de fabrication.

La présente invention permet de remédier en tout ou partie aux inconvénients techniques actuellement connus. Une solution proposée apporte une réponse à au moins un des problèmes précédemment exposés, en particulier celui de la séparation entre deux parties (un support et un substrat) après une étape d'assemblage. Non limitativement, l'invention peut dans le même temps apporter une solution d'encapsulation. En effet, les principes de modes de réalisation optionnels de cette invention ont trait à la problématique d'encapsulation des dispositifs microélectroniques réalisés sur substrats, de préférence fins donc fragiles, fixés délibérément sur des supports plus épais mais aussi aux difficultés de désolidarisation des socles formés par les substrats fragiles et les supports épais.

### Résumé de l'invention

Un aspect de modes de réalisation de l'invention concerne un procédé de fabrication d'un dispositif électronique comprenant un substrat. Le procédé comprend une étape d'assemblage du substrat, par une zone de solidarisation d'une première face du substrat, avec une zone de solidarisation d'une première face d'un support, puis une étape de désolidarisation du substrat relativement au support. De manière avantageuse, le procédé comprend :
- après l'étape d'assemblage, la formation d'un film sur le substrat, ledit film étant configuré pour adhérer à une zone d'adhésion d'une deuxième face du substrat opposée à la première face du substrat, la force d'adhésion entre le film et la zone d'adhésion de la deuxième face du substrat étant choisie supérieure à la force de solidarisation entre la zone de solidarisation du support et la zone de solidarisation de la première face du substrat ;
- une traction sur le film avec une force de traction configurée pour vaincre la force de solidarisation sans vaincre la force d'adhésion.

Suivant un aspect optionnel de l'invention, on forme au moins un composant, au moins en partie après l'étape d'assemblage et avant la formation du film.

Un autre aspect de modes de réalisation de l'invention s'adresse à un dispositif qui peut être obtenu par le procédé de l'invention. L'invention concerne aussi l'utilisation d'un film, notamment polymère, pour la séparation d'un substrat et d'un support, par traction sur le film.

Un autre aspect de l'invention est relatif à un outil de traction sur le film. Suivant une possibilité avantageuse, cet outil comprend un élément roulant configuré pour qu'au moins une partie de bordure du film soit fixable à une surface périphérique de l'élément roulant, l'élément roulant étant rotatif par une rotation configurée pour enrouler le film sur la surface périphérique de l'élément roulant.

Un intérêt potentiel de l'invention est de profiter de la présence du film pour s'en servir comme vecteur de désolidarisation du substrat relativement à son support. Le film produit éventuellement ainsi deux fonctions, fort différentes, et évite le recours à des techniques complexes pour séparer substrat et support.

### Introduction des Dessins

Les dessins ci-joints sont donnés à titre d'exemples et ne sont pas limitatifs de l'invention. Ils représentent seulement un mode de réalisation de l'invention et permettront de la comprendre aisément.
- La figure 1 est une vue de dessus d'un exemple de support.
- La figure 2 est une vue de profil du support de la figure 1.
- La figure 3 est une vue de profil présentant un assemblage d'un substrat plus fin que le support sur ce dernier.
- La figure 4 est une vue partielle en coupe montrant la fabrication d'un composant électronique dans la partie substrat, sous forme d'un empilement capacitif simple.
- La figure 5 présente en perspective un ensemble de composants répartis sur une face du substrat.
- La figure 6 montre, sur la base de l'exemple de la figure 5, le recouvrement par un film servant à encapsuler le substrat.
- La figure 7 est une vue partielle en coupe illustrant la succession de couche ainsi obtenu, avec l'encapsulation offerte par le film.
- La figure 8 présente une étape de la désolidarisation du substrat relativement au support.
- La figure 9 montre qu'une traction sur le film désolidarise le substrat relativement au support.
- La figure 10 présente une variante de l'exemple de la figure 5.
- La figure 11 montre une variante de la figure 3 ;
- La figure 12 offre une variante de la figure 7 ;
- La figure 13 illustre un premier exemple de moyen de traction ;
- Les figures 14 et 15 sont deux autres possibilités de moyen de traction sur le film.

Les épaisseurs des différentes couches représentées sur les figures ne sont pas forcément à l'échelle. Notamment, l'épaisseur du substrat peut être bien inférieure (par exemple de dix fois) à celle représentée simplement environ trois fois plus petite que celle du support.

### Description détaillée

D'autres buts et avantages apparaîtront au cours de la description qui suit qui présente des modes de réalisation de l'invention illustratifs mais non limitatifs

Avant d'entrer dans le détail de ces modes de réalisation, on introduit brièvement ci-après des variantes préférées mais non limitatives utilisables seules ou selon toutes combinaisons entre elles, l'invention est telle que :
- la formation du film 15 est configurée pour créer une portion de film 15 débordant de la deuxième face du substrat 5 ; de préférence, cette portion débordante fait saillie latéralement au-delà du substrat 5, de sorte qu'elle ne soit pas en vis-à-vis de ce substrat suivant l'épaisseur de ce dernier ;
- la formation du film 15 est configurée pour ménager au moins un espace non rempli du matériau du film 15 au-dessus de la marche 3 ; l'utilisation de plusieurs marches successives dans la zone périphérique 2 permet d'avoir plusieurs vides successifs entre le support 1 et le film 15 et favoriser ainsi l'arrachement du film 15 dans cette zone périphérique 2 ;
- la force de traction est dirigée suivant la dimension en épaisseur du substrat ;
- la traction est opérée en plusieurs points, avantageusement, ces points sont alignés dans un plan contenu dans la zone périphérique 2 du film 15;
- le film 15 est configuré pour encapsuler la deuxième face du substrat 5;
- le film est désolidarisé de la deuxième face après traction ;
- le film 15 comporte au moins une première couche 15 de film configurée pour adhérer au moins sur la zone d'adhésion 7 de la deuxième face du substrat 5, et au moins une deuxième couche 17 de film au-dessus de ladite première couche de film, l'au moins une deuxième couche de film comprenant au moins une couche étanche à l'atmosphère extérieure, telle l'eau et ses oxydants ;
- on forme, dans le substrat, au moins une zone ruptable 24, plus fragile que le reste du substrat 5, la traction étant configurée pour rompre la zone ruptable 24,
- le dispositif électronique comporte au moins un composant électronique formé à partir de la deuxième face du substrat 5 au moins en partie après l'étape d'assemblage et avant la formation du film 15 ;
- au moins un composant électronique est un empilement capacitif 9 ou une batterie ou un composant électrochrome ; dans ce cas, le film 15 est avantageusement transparent aux rayonnements dudit composant ;
- le composant est encapsulé au moyen du film ;
- la formation du film est configurée pour isoler au moins un composant de l'environnement extérieur ; l'environnement extérieur peut être un espace entre le dispositif et d'autres dispositifs et/ou entre le dispositif et un boitier et/ou une couche d'air atmosphérique jouxtant cette zone du dispositif.

Les caractéristiques indiquées précédemment ne sont qu'optionnelles.

Le procédé de l'invention permet de fabriquer un dispositif dit électronique en ce sens qu'il comprend des parties électriques sur un support qui peut, de préférence, comprendre un substrat par exemple en matériau semi-conducteur notamment en verre ou à base de silicium, ou encore en céramique, mica, quartz ou autre. Il peut s'agir d'un dispositif microélectronique. On entend par microélectronique notamment l'ensemble des techniques de microélectronique et de nanoélectronique. Les dispositifs que l'on peut former peuvent s'inscrire dans des systèmes du type systèmes micro-électro-mécaniques dits MEMS et/ou avec des fonctions optiques. Ce dispositif peut ainsi comprendre des composants. Préférentiellement, il pourra s'agir de cellules de batteries, à base d'empilements d'électrodes formant des ensembles capacitifs. Il peut s'agir de composants plus simples, tels des lignes de distribution électrique.

Dans le cadre de la présente invention, des termes tels que « sur » ou « au-dessus » ne signifient pas obligatoirement « au contact de ». Ainsi, par exemple, la présence d'une couche sur une autre couche ne signifie pas obligatoirement qu'ils sont en contact. Cela ne signifie pas non plus que l'élément situé au-dessus de l'autre le recouvre totalement.

Le terme « épaisseur » s'entend, à moins qu'il en soit disposé autrement, d'une dimension suivant l'épaisseur du substrat, par exemple perpendiculairement à un plan d'une surface du substrat. De même, le terme « largeur» s'entend, à moins qu'il en soit disposé autrement, d'une dimension perpendiculaire à l'épaisseur du substrat.

Le substrat décrit plus loin est avantageusement un substrat fin, par exemple d'une épaisseur comprise entre 100 et 500 µm voire inférieure à 100 µm, généralement appelé substrat ultrafin. Le reste ou une partie des organes microélectroniques, tels des cellules de batteries, est réalisée sur le substrat fin. Le terme support ou porte substrat ou porteur, ou encore système convoyeur s'entend notamment de substrats dits épais, ayant de préférence une épaisseur supérieure à 500 µm.

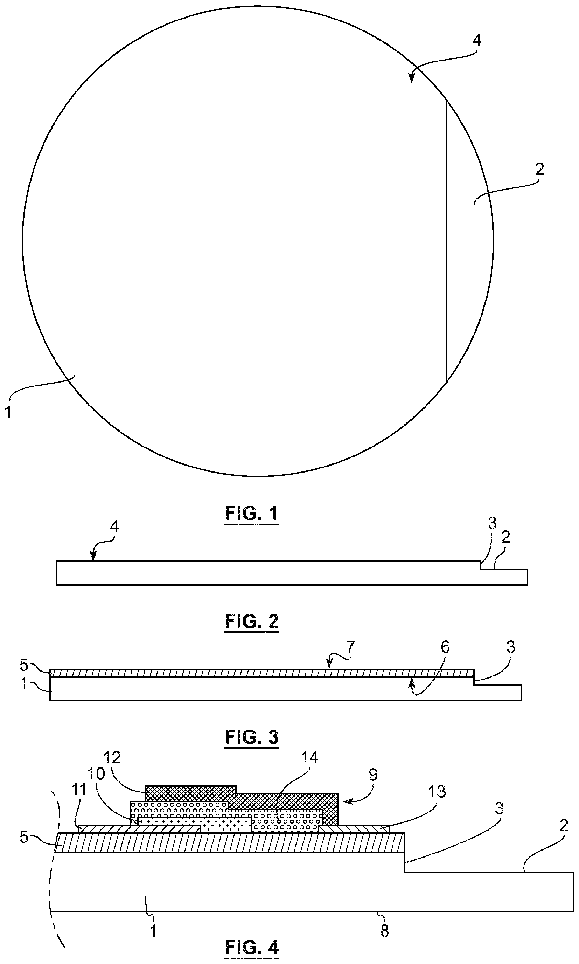

En référence à la figure 1, un élément de départ du procédé de l'invention est un support 1 par exemple en verre. Il peut avoir la géométrie d'une plaque du type « wafer », par exemple avec un diamètre de 200 mm ou 300 mm, ou celle d'une plaque rectangulaire. Son épaisseur permet de préférence de disposer d'une rigidité supérieure à celle du substrat 5 qui va lui être rapporté. Une première face du support 1, encore appelée face supérieure, sert à recevoir une première face, en vis-à-vis, du substrat 5. L'autre face 8 du support peut être fixée sur un outillage. Ces deux faces sont préférentiellement planes.

La première face est cependant avantageusement configurée pour offrir d'une part la capacité d'accueillir le substrat 5 et, d'autre part, pour permettre un décollage de ce dernier par un effort appliqué sur un film 15 amené à recouvrir le substrat 5. Les étapes de formation et d'utilisation du film 15 sont présentées en détail plus loin. La première face du support 1 comporte à cet effet de préférence une première zone surfacique au niveau de laquelle le substrat 5 est solidarisable, dite zone de solidarisation 4. Une deuxième zone, dite zone périphérique 2 assure le contact avec une partie du film 15 ; elle est adjacente à la zone de solidarisation 4 et permet le débordement du film relativement à la deuxième face du substrat 5 que le film va couvrir. Avantageusement, la zone périphérique 2 dispose d'une énergie de surface inférieure à celle de la zone de solidarisation 4. Cette énergie de surface inférieure peut être produite, notamment, par une tension superficielle inférieure, une rugosité différente offrant une moindre adhérence, une porosité différente ou encore un caractère hydrophile (ou respectivement hydrophobe) moins marqué que celui de la zone de solidarisation.

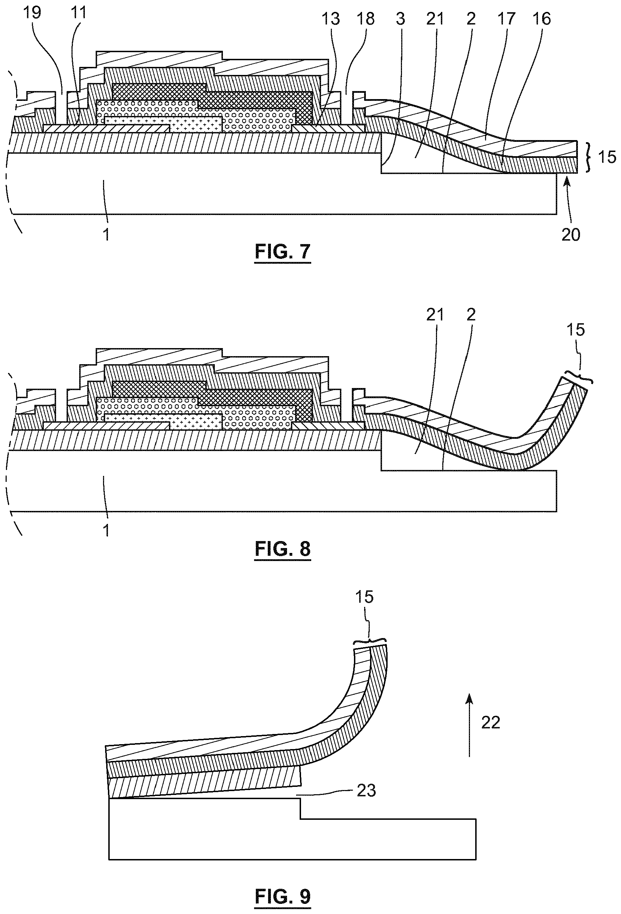

L'énergie de surface modifiée de la zone périphérique 2 peut être produite par fonctionnalisation de la première face du support 1 à cet endroit, relativement à la zone de solidarisation 4. La fonctionnalisation peut être réalisée par des procédés de détourage mécanique ou par un traitement de surface adéquat. Les figures 1 et 2 montrent la fonctionnalisation par formation d'un relief, de préférence une marche 3, par exemple par micro-usinage consistant à graver la marche 3 au niveau de la zone périphérique 2. On peut aussi conférer cette forme géométrique spécifique au support 1 lors de sa production. Une autre possibilité, privilégiée dans le cadre de cette invention, consiste à façonner le support 1 initialement plan par des techniques de fonctionnalisation de parties externes. Ces techniques font appel notamment aux procédés d'usinage par abrasion réservés aux matériaux fragiles de dureté élevée comme les verres. L'opération d'usinage a pour objectif d'imposer au support 1, par enlèvement de la matière, des dimensions et/ou un état de surface (dont rugosité, intégrité mécanique et physico-chimique) de la zone périphérique 2. A titre d'exemple, les procédés d'abrasion comme la rectification, le rodage ou le polissage confèrent à la pièce une forme géométrique précise et une rugosité contrôlée. La forme et la hauteur de la marche 3 ainsi que son procédé de réalisation sont des paramètres qui peuvent être ajustés en fonction de la nature des dispositifs microélectroniques. La marche 3 créée au niveau de la zone périphérique 2 a de préférence une épaisseur supérieure ou égale à l'épaisseur du film 15. Elle a, dans les illustrations, un profil rectiligne perpendiculaire à la première face du support 1, mais ce cas n'est pas limitatif et un profil différent, par exemple oblique, peut être retenu. La marche 3 peut posséder une hauteur au moins deux fois supérieure à l'épaisseur du film 15 ultérieurement formée. La hauteur peut par exemple être de 100 µm. On comprend que la marche 3 produit une zone périphérique 2 disposant d'une portion, typiquement en regard de l'espace 21 montré en figure 7, au niveau de laquelle le film 15 ne sera pas en contact, et une portion, plus éloignée de la marche 3 en direction du bord du support, au niveau de laquelle un contact du film sera opéré ; cette configuration engendre, en moyenne une adhérence limitée entre le film 15 et la zone périphérique, limitant ainsi, autrement dit, l'énergie de surface globale de cette zone 2 relativement au film 15.

La zone périphérique 2 débouche de préférence au niveau de la tranche du support 1. Sa largeur, dans le plan de la première face du support 1 peut être de l'ordre de 10 fois la hauteur de la marche lorsque celle-ci est employée.

Une autre manière de fonctionnalisation de la partie périphérique 2 est basée sur les techniques de traitement de surface. L'objectif visé est de modifier l'énergie de surface d'une partie ou de la totalité de la zone saillante pour la rendre défavorable à l'adhésion du film 15. Le traitement de surface peut être choisi en fonction de la nature des adhésifs de laminage utilisés pour le film 15 et du matériau constituant le support 1 épais. Il inclut toutes les techniques permettant de réduire les forces de collage comme les procédés de dépôt des couches minces, de traitement et gravure plasma ou encore d'abrasion mécanique ou chimique. Nous pouvons citer à titre d'exemple, les dépôts de couches minces de composition parfaitement stoechiométrique caractérisées par l'absence des liaisons pendantes type OH.

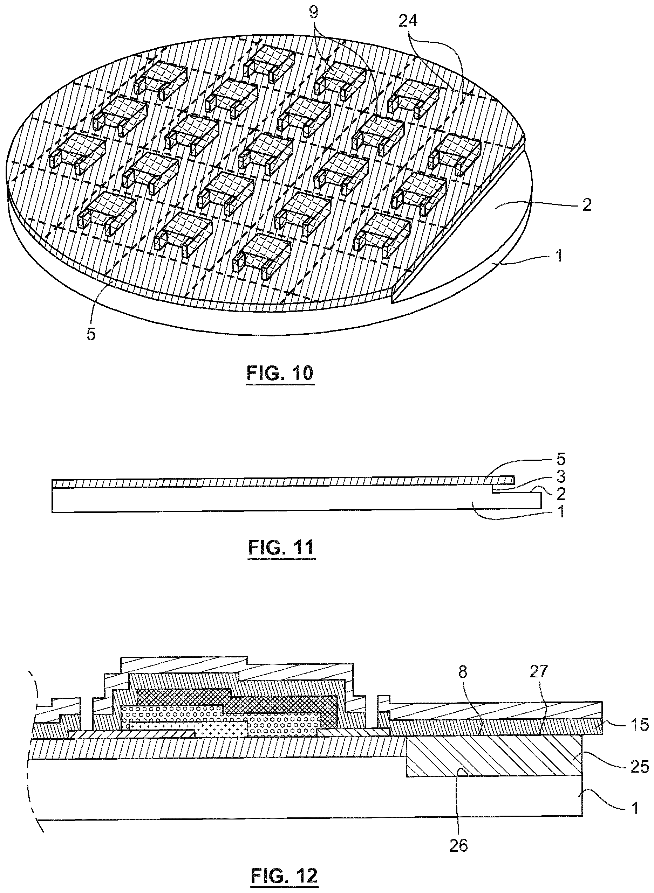

Dans le cas des figures 1 et 2, la zone périphérique est une zone délimitée par une corde tirée à partir du bord circulaire du support 1 et par une portion de ce bord. D'autres formes sont possibles. Par exemple, la zone périphérique peut former un contour fermé autour de la zone de solidarisation 4 de sorte à la ceinturer totalement. En outre la zone périphérique 2 peut être en plusieurs surfaces placées à différents endroits de la première face du support. Enfin, la figure 12 exposée en détail plus loin montre que la zone périphérique 2 peut, au moins en partie, être formée sur une partie amovible du support 1, sous forme de cale. La cale est choisie avantageusement en un matériau favorisant l'adhésion avec le film 15 et par exemple en un même matériau que le substrat 5.

La zone de solidarisation 4 reçoit, par sa première face, une zone de solidarisation 6 complémentaire du substrat 5, comme cela apparait en figure 3. Ce substrat 5 est avantageusement moins épais que le support 1 et peut être de même nature, par exemple en verre ou non. On entend ici par substrat 5 non seulement la base de substrat 5 illustrée en figure 3 mais aussi globalement les composants qui seront éventuellement formés sur cette base, comme des empilements capacitifs 9 par exemple. La zone d'adhésion 7 de la deuxième face du substrat 5, au niveau de laquelle le film 15 sera déposé, comprend donc potentiellement des surfaces de ces composants. En particulier, la surface supérieure des composants peut participer à la zone d'adhésion 7. La base de substrat 5 tel que présentée en figure 3 et servant de support de réalisation des composants microélectroniques est ici géométriquement en retrait par rapport au support 1, en ce sens qu'il ne couvre pas la marche 3. Par conséquent, il présente naturellement une marche supplémentaire définie par son épaisseur. Dans cet exemple, le substrat 5 a la même forme et les mêmes dimensions que la zone de solidarisation 4.

Le substrat 5 peut être fixé sur son support 1 en utilisant différentes techniques connues dans l'état de l'art. A titre indicatif, la fixation temporaire par application d'un champ électrostatique sans recours à une électrode est l'une des techniques préférentielles qui présente la particularité d'être compatible au regard de l'application des micro-batteries. Cette technologie permet en effet une fixation même dans des conditions défavorables de température ou d'environnement chimique, que l'on rencontre typiquement pour les fabrications de micro-batterie, avec des recuits et des attaques chimiques notamment. En exposant l'assemblage formé par le substrat et le support au champ électrostatique, des charges opposées se forment à l'interface des deux pièces, par exemple deux verres, et tendent à renforcer l'attraction des surfaces et la qualité du clampage. Le protocole de clampage consiste ensuite à laminer le substrat 5 sur le support 1 tout en chassant l'air entre les deux pièces afin de prévenir la formation des bulles. Une maitrise du protocole de laminage garantie une bonne adhérence entre les deux surfaces.

Selon un exemple de réalisation, les assemblages sont formés par clampage électrostatique des matériaux verres AF32® de la société SCHOTT AG, ayant une rugosité RMS (en anglais Root Mean Square) préférentiellement inférieure ou sensiblement égale à 1 nm. Les caractéristiques thermiques et mécaniques sont respectivement exprimées par les valeurs de coefficient d'expansion thermique à 3.2x10⁻⁶ K⁻¹ et le module de Young à 74.8 kN/mm². L'épaisseur du support 1 est de l'ordre de 500µm alors que celle du substrat 5 ici en verre est de 50µm. Disposer d'une surface extérieure nette de toute trace de pollution et de particules étrangères impose un nettoyage fréquent. L'opération de suppression des résidus organiques et particulaires consiste par exemple à tremper les deux verres dans des bains de détergents (savon) et d'ultrasons (2 minutes) suivis des procédés de rinçage à l'eau avant de procéder au séchage sous air des surfaces. Ces séquences d'opérations nettoyage/rinçage/séchage peuvent être répétées de nombreuses fois jusqu'à élimination totale des résidus. Une charge haute tension de 5kV à polarité positive est appliquée à la surface du support 1 incluant la zone périphérique 2 en utilisant un chargeur haute tension électrostatique. En parallèle, une charge équivalente à polarité inverse est appliquée à la surface de contact du substrat 5. La mise en contact des deux verres par un procédé de laminage adapté (tel qu'à une pression de 1 à 3 bars et à une vitesse d'environ 0.5 m/mn) permet au final la réalisation des assemblages selon la configuration de la figure 3.

A ce stade, le substrat 5 est donc temporairement fixé sur le support 1, comme en figure 3.

La figure 4 montre que l'on a ensuite fabriqué, ou plus généralement formé, un composant électronique, les composants pouvant être réalisés par empilement de différentes couches actives. La formation du composant s'entend de toute étape ou suite d'étapes technologiques permettant de parvenir à une présence dudit composant sur le substrat. Il peut s'agir d'une fabrication complète ou partielle à partir du substrat ou d'un report total ou partiel sur celui-ci.

Dans l'exemple de la figure 4, on a réalisé des connecteurs 11, 13, pour le raccordement électrique de chacune parmi deux électrodes 10, 12 empilées et espacées l'une de l'autre par un isolant 14. Les techniques habituelles de fabrication de cellules capacitives peuvent être mises en oeuvre, notamment avec des procédés de dépôts (dépositions sous vide par voie chimique ou vapeur par exemple) et de gravure (chimique ou plasma par exemple). Les matériaux conducteurs et isolants employés peuvent être conventionnels.

L'empilement 9 d'une batterie élémentaire présenté dans la figure 4 peut être constitué de collecteurs de courant cathodique et anodique (sous forme de connecteurs 11, 13 en figure 4) notamment de nature métallique (Titane, Or, Aluminium platine, tungstène ou tous autres métaux utilisés en tant que collecteur) disposés sur le substrat par exemple en verre AF32®. Les couches actives de la micro-batterie désignent ici les électrodes, négative et positive 10, 12 et l'électrolyte qui est l'isolant 14 situé entre les deux électrodes. L'électrode positive 10 (cathode) est de préférence en un matériau ayant une bonne conductivité électronique et ionique (par exemple : TiOS, TiS2, LiTiOS, LiTiS2, LiCoO2, V2O5). L'électrolyte est un isolant électronique avec une forte conductivité ionique (par exemple : LiPON, LiPONB, LiSiCON) L'électrode négative 12 est une couche qui peut être constituée exclusivement du lithium métallique ou d'un matériau sciemment lithié. La configuration de la figure 4 est donnée à titre indicatif afin d'illustrer les principes de cette invention.

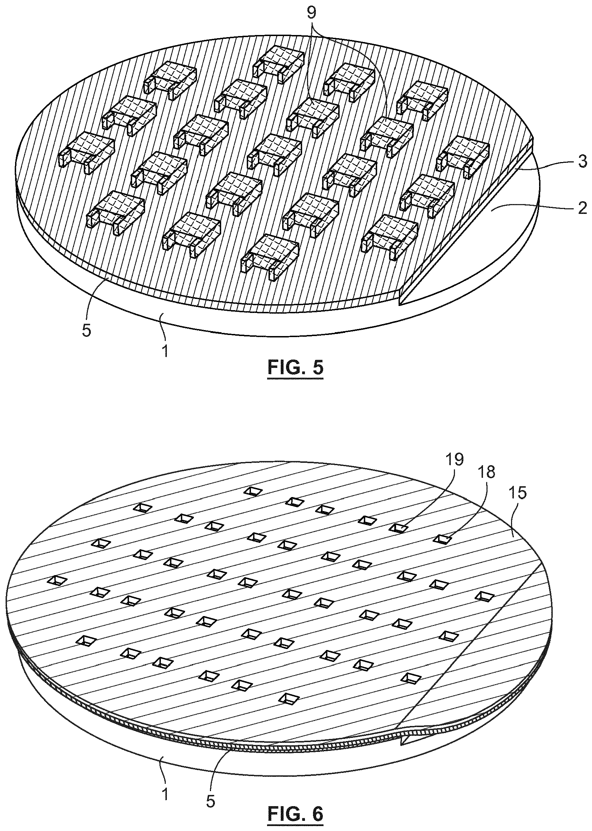

La figure 5 présente un résultat potentiel, avec une pluralité de composants 9 en surface supérieure de l'ensemble.

Ces étapes sont par la suite complétées par une encapsulation basée préférentiellement sur les techniques de laminage. Un film est formé au-dessus du substrat 5, au niveau d'une zone d'adhésion 7 du film 15, incluant dorénavant les composants électroniques. Il n'est pas absolument nécessaire que le film 15 couvre l'intégralité de la deuxième face du substrat 5 comme en figure 6 mais il est bien entendu souhaitable que le recouvrement isole pour le moins efficacement les composants de l'environnement extérieur.

De manière générale, le film 15 est une partie, de préférence à base ou faite de polymères, et formant une couche flexible au-dessus du substrat. De manière avantageuse, le film 15 est choisi dans la gamme des films barrières à l'humidité et à l'oxygène. Il peut s'agir par exemple d'un système multicouche formé par l'alternance de couches adhésives et de couches barrières. Dans le cas des figures, le film 15 comprend une première couche 16 assurant l'adhésion et une deuxième couche 17 pouvant avoir plus spécifiquement une fonction de barrière à l'eau et/ou aux gaz. Suivant les cas d'application, il peut être utile d'utiliser des systèmes d'encapsulation très conformables permettant d'accommoder la topographie de surface relative aux différents marches et reliefs formés aux contacts des différents éléments à recouvrir. La force d'adhésion du film 15, dans sa couche 16 servant à l'adhésion, vis-à-vis du substrat 5 incluant le ou les composants 9 microélectroniques est de préférence a minima deux fois plus importante que la force d'adhésion créée par l'assemblage substrat 5 et support 1.

Des exemples indicatifs sont donnés ci-après de manière plus précise pour cette encapsulation. Le film 15 d'encapsulation est sélectionné essentiellement pour ses propriétés barrières mais aussi pour ses propriétés mécaniques. En effet, une des spécificités des films d'encapsulation concerne leurs propriétés d'accommodation de la topographie formée par l'ensemble des trois éléments (empilement de composants, épaisseur du substrat 5, hauteur de la marche 3). Dans la pratique, le film 15 peut comprendre une ou des couches barrières et une couche d'adhésif permettant son collage sur les composants fabriqués sur le substrat 5. Le procédé de collage fait appel par exemple aux techniques telles que le laminage ou le scellement. Il est souhaitable que la force d'adhésion entre le film 15 et les différentes surfaces (composants, substrat, et éventuellement d'une partie de la zone périphérique 2) soit plus importante que la force d'adhésion créée lors de l'opération de clampage électrostatique entre le substrat 5 et le support 1.

Le film 15 peut se présenter sous forme d'un feuillard constitué d'une monocouche homogène ou bien sous forme d'un multicouche hétérogène. Il est optionnellement choisi dans la famille des matériaux hautement barrières aux éléments oxydants présents dans l'atmosphère. Les feuillards métalliques (épaisseur inférieure à 300µm) à base d'aluminium ou à base d'acier (fer blanc, fer noir, fer chromé, acier inoxydable,...) sont des exemples typiques pour réaliser ce film 15. Optionnellement, ces feuillards peuvent être couplés avec des films thermoplastiques d'une épaisseur inférieure à 100 µm (PEN, PET, PP, PI...) qui permettent de renforcer la tenue mécanique du système d'encapsulation.

Le système d'encapsulation préconisé est équipé d'une couche agissant comme un adhésif dont l'épaisseur est fixée délibérément en fonction de plusieurs paramètres : épaisseur d'empilement 9, hauteur de la marche, diamètre de la zone périphérique 2. Cela confère au système d'encapsulation la propriété de conformabilité garantissant ainsi une protection efficace des couches actives des empilements 9. L'adhésif peut être choisi prioritairement pour ses propriétés de collage, d'isolation électrique et de compatibilité chimique avec les couches actives du substrat 5 et de ses composants, tels des empilements 9. Il peut être sensible à la pression, à la température ou aux rayons UV. Il est obtenu par exemple à partir des films polymères à base d'acrylique, de silicone, de caoutchouc ou d'un mélange de ces matières. Optionnellement, les adhésifs employés peuvent être chargés avec des inclusions particulaires ou des absorbeurs d'oxygène et d'eau permettant d'améliorer leur étanchéité.

Selon un mode de réalisation, le film 15 comprend un complexe d'aluminium (de 20µm d'épaisseur) et du PET (de 25µm d'épaisseur), pour la couche 17. Le film adhésif de la couche 16 est notamment un thermodurcissable d'une épaisseur de 25µm. Ces films peuvent être laminés sur l'ensemble sous-jacent. Typiquement, les conditions de laminage sont choisies à 90°C pour la température, à 1 bar pour la pression et à 5cm/s pour la vitesse. Le film 15 d'encapsulation reporté est en contact direct avec le substrat 5 et l'ensemble des composants qu'il porte ainsi qu'une partie ou la totalité de la zone périphérique 2. L'opération de laminage est avantageusement réalisée de façon à faire déborder une partie du film 15 par rapport aux dimensions du support 1 formant ainsi une longuette par exemple de quelques millimètres sous forme de partie de bordure 20 en figure 7. Cet effet est mis à profit pour réaliser les opérations de séparation ultérieure du substrat 5 relativement au support 1.

Le procédé de laminage est mis en oeuvre de façon à faire correspondre la partie adhésive du film 15 d'encapsulation avec les couches actives des composants microélectroniques (typiquement leur zone supérieure en saillie relativement à un plan de la deuxième face du substrat 5), une partie du substrat 5 en dehors des composants et une partie du support 1 incluant la zone périphérique 2. En clair, le système d'encapsulation a une partie débordant du substrat 5 contenant les composants microélectroniques, de sorte à couvrir aussi une partie au moins du support 1 et notamment une partie au moins de la zone périphérique 2. Il peut aussi déborder du support 1, comme le montre la position de la bordure 20 du film 15 en figure 7. Cette figure montre aussi que la marche 3 du support préserve un espace 21 entre le film 15 et une partie de la zone périphérique 2. Dans cet espace, aucun contact entre le film et le support 1 n'est produit et cela correspond à une zone de laquelle le film pourra aisément être retiré.

A l'issue du procédé de laminage, les composants microélectroniques réalisés sur le substrat 5 préalablement fixé sur le support 1 sont totalement encapsulés des espèces oxydantes. Selon les applications, notamment dans le cas des empilements capacitifs 9 illustrés, il peut être nécessaire de produire des accès pour le raccordement électrique des composants, au travers du film 15. Les figures 6 et 7 montrent des exemples de tels accès. Par exemple, la figure 7 illustre un accès 18 au travers du film 15 pour accéder au connecteur 13 et un accès 19 pour accéder au connecteur 11. Les accès sont par exemple des trous perforés de section adaptée à la reprise de contact souhaitée. La perforation du film est notamment faite par gravure laser ou par retrait mécanique. Avantageusement, ces ouvertures offrent une solution d'alignement lors du procédé de report et permettent de s'affranchir de la formation des bulles lors des procédés de laminage.

Lorsque les étapes de fabrication sur le substrat 5 sont terminées, il s'agit de désolidariser ce dernier du support 1.

Le procédé de séparation du substrat et du support 1 peut par exemple comprendre une étape consistant à appliquer un mouvement de traction du film 15 sur les parties qu'il recouvre. La force appliquée est de préférence telle qu'elle surmonte la force de solidarisation du substrat 5 et du support 1. Sa direction 22 a de préférence une composante non nulle, avantageusement majoritaire, suivant une direction perpendiculaire au plan de la deuxième face du substrat 5. Une trajectoire de mouvement appliquée au film par sa bordure permet de produire cette force de séparation et cette trajectoire tend préférentiellement à éloigner la bordure du film du substrat 5. Dans la pratique, l'angle formé par la trajectoire de ce mouvement avec le plan de la zone périphérique 2 du support 1 peut être supérieur à 0° et sensiblement égal à 90°.

La force de traction introduite est orientée préférentiellement selon un axe vertical avec un tirage du bas vers le haut. Le ou les lieux d'application de cette force peuvent correspondre à des zones (ponctuelles ou linéaires ou surfaciques) de préhension de la longuette formant la partie 20. Par exemple, deux zones peuvent être réparties à égale distance du milieu de la largeur de la longuette. Optionnellement, il est possible de multiplier les points d'application de la force pour renforcer l'étendue de la force de traction. Il est possible qu'au moins une zone d'application de force soit située à un coin du film, par exemple à deux coins se suivant du film 15, de sorte à solliciter tout le film lors de la traction.

De plus, la force d'adhésion au niveau de l'interface formée par le film 15 et le substrat 5 embarquant les composants est avantageusement plus forte que la force d'adhésion au niveau de l'interface créée par le contact entre la partie adhésive du film 15 et la zone périphérique 2 du substrat 5. En outre, la zone périphérique 2 remplit de préférence le rôle d'une zone d'amorce du film 15 lors du procédé de séparation. Cette amorce est favorisée par la présence d'un espace 21 comme en figure 7 et 8. Le volume engendré par cette zone vide présente la particularité d'être ajustable. Concrètement, ce volume peut être modulé en jouant sur plusieurs paramètres (tels que l'épaisseur du film 15, l'épaisseur du substrat 5, la marche 3 de la zone périphérique 2) permettant ainsi de faciliter la procédure de désolidarisation. La figure 9 montre le début de la désolidarisation produite par traction sur le film, avec une zone 23 de désolidarisation qui va progressivement correspondre à toute la zone de solidarisation 4 d'origine.

La valeur de la force de désolidarisation à appliquer dépend de la force de résistance à la décohésion interfaciale de l'assemblage produit entre le support 1 et le substrat 5 lors du procédé préliminaire. En pratique, la nature et l'état de surface des matériaux, tels des verres, utilisés dans la fabrication des substrats 5 et des supports 1 sont des paramètres que l'on peut employer pour régler la force du clampage et par conséquent la fiabilité du déclampage. Concrètement, les différences de coefficient d'expansion thermique et du module de Young entre, d'un côté le substrat 5 et, de l'autre, son support 1 peuvent impliquer un stress mécanique inhomogène des deux matériaux, synonyme de réduction de l'adhérence et de défaillance de l'assemblage. Afin de réduire ce stress intrinsèque à l'assemblage, il est préféré d'utiliser des matériaux à valeur de coefficient d'expansion thermique et de module de Young les plus proches possible les uns des autres, notamment avec des seuils de tolérance entre 0 et 10%. Ainsi, le support 1 peut être choisi dans la même famille de matériaux que le substrat 5. A titre d'exemples non exhaustifs, on pourra employer les verres issus de la famille des borosilicates. Il est possible aussi d'utiliser les dérivés des produits borosilicates comme les verres borosilicatés sans alcali ou encore les verres boro-alumino-silicatés-alcalino-terreux issus de terres rares alcalines. D'autre part, on peut améliorer la solidarisation du support 1 et du substrat 5 par l'application d'un nettoyage des deux surfaces avant l'opération de fixation. Ce nettoyage consiste par exemple à réaliser des trempages dans des bains savonnés suivis d'ultrasons. L'enchaînement des opérations de nettoyage permet de réduire la rugosité des surfaces de contact des deux surfaces à assembler par élimination des défauts particulaires inhérents pour le procédé de clampage.

On peut aussi privilégier des verres thermiques qui présentent une haute résistance à la chaleur et aux changements de température tout en garantissant une très bonne conductivité thermique à travers l'assemblage (support 1/substrat 5), pour la réalisation de batteries par exemple. Le choix des matériaux des substrat et support peut être fonction de propriétés optiques ou diélectriques spécifiques à d'autres applications comme les composants issus de la technologie de l'électronique organique.

Dans le cas de support et de substrat en verre, le mouvement de pelage du film 15 en polymère peut être réalisé avec un équipement dédié. Le socle formé par le support 1 et le substrat 5 contenant les composants électroniques protégés par le film 15 est maintenu par une aspiration sous vide. Selon la figure 8 et de façon préférentielle, ce mouvement au moins en partie perpendiculaire à l'épaisseur du film 15 et/ou du substrat 5 orienté du bas vers le haut (soit à l'opposé du support 1) est initié au niveau de la longuette de la bordure 20 avec un angle de 90°C et une force de 6 N/cm (correspondant à une tension de surface) selon une vitesse constante de 300 mm/mn. Ainsi, la force de pelage F est très faible en comparaison à la force de rupture du film 15 par rapport au substrat 5 en verre, notamment du type AF32® et ses composants. Après initiation de la rupture selon le schéma de la figure 9, les fissures matérialisées par l'élément 23 se propagent au niveau de l'interface formée. Ces fissures sont caractérisées par un angle entre support et substrat qui augmente progressivement avec la vitesse de sollicitation régissant le mouvement de traction du film 15. Dans ce cas, le film 15 reste solidaire uniquement et entièrement du substrat 5 en verre AF32® comportant l'ensemble des composants fabriqués.

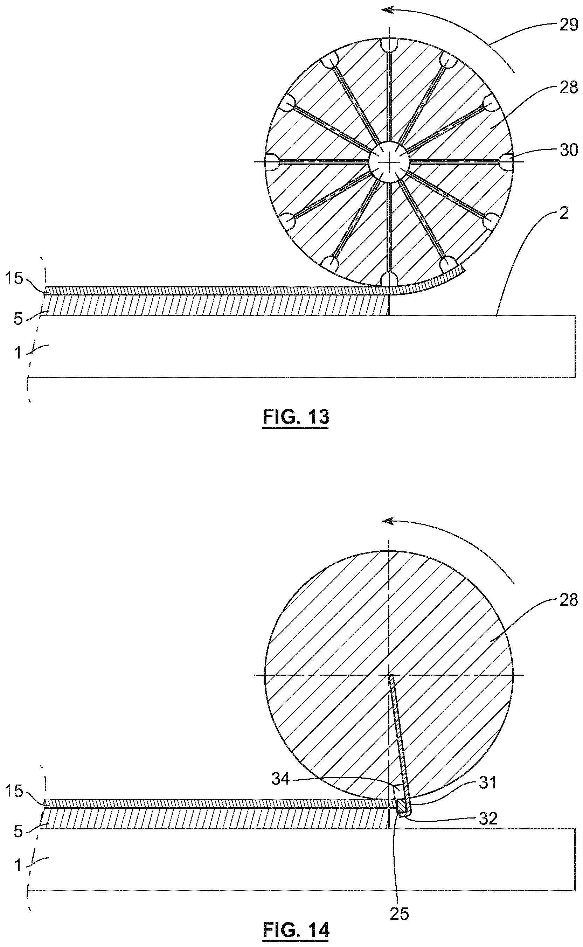

La figure 13 illustre un exemple de moyens utilisables pour réaliser la traction sur le film 15. Un élément roulant 28 comporte une surface extérieure de préférence cylindrique et apte à un roulement sur la surface supérieure du film 15. De préférence, la dimension en longueur de l'élément 28 est au moins égale à la dimension correspondante du film 15 de sorte que ce dernier peut entrer en contact suivant toute sa dimension avec l'élément 28. Selon cet aspect de l'invention, l'élément roulant 28 est configuré pour opérer un enroulement du film 15 sur sa circonférence. De préférence, cette dernière est suffisamment grande pour autoriser un enroulement complet du film 15 sans chevauchement de parties de ce film autour de l'élément 28. Typiquement, on peut positionner l'élément 28 dans une zone de bordure du film 15, en regard de la zone périphérique 2. L'amorce de coopération entre l'élément roulant 28 et le film 15 peut donc dans cet exemple s'opérer dans une zone où le film 15 est libre ou faiblement fixé. De préférence, l'élément roulant 28 comporte un système configuré pour maintenir le film 15 sur son pourtour.

Dans le cas de la figure 13, ce système de maintien comprend une pluralité d'embouchures 30 aptes à s'appliquer sur la surface supérieure du film 15 et coopérant avec un circuit d'aspiration de sorte à générer une dépression au niveau desdites embouchures, au moins pour celles qui sont en regard du film 15. Notamment, le circuit d'aspiration peut s'étendre dans le corps de l'élément 28 sous forme de canalisations et comprendre un organe de dépression d'air ou un organe de raccordement à un circuit d'air en dépression extérieur. On comprend que, lorsque l'élément roulant 28 est dans la disposition de la figure 13, certaines embouchures 30 produisent un effet d'aspiration du film 15 au niveau de sa bordure. Ensuite, un mouvement de rotation opéré suivant la direction 29, avantageusement produisant une rotation sans glissement de l'élément roulant 28 le long du film 15 suivant un axe de rotation correspondant à l'axe longitudinal de l'élément roulant, permet d'enrouler progressivement tout ou partie, et avantageusement l'ensemble, du film 15.

De préférence, les embouchures 30 sont régulièrement réparties le long de la circonférence de l'élément roulant 28 et, de manière générale, sur toute la surface susceptible de rentrer en contact avec le film 15.

La figure 14 présente une variante dans laquelle la préhension du film 15 s'opère par un accrochage d'une extrémité du film 15. Une tige 31 solidaire de l'élément roulant 28 par une extrémité proximale et disposant, à une extrémité distale, d'un crochet 32, définit une zone de blocage mécanique de l'extrémité du film 15 relativement à l'élément roulant 28. Dans ce mode de réalisation, il est avantageux qu'une cale 25 soit solidaire du film 15 à ce niveau de sorte à assurer une coopération suffisamment rigide avec le crochet 32. Ainsi, la cale 25 sert d'élément intermédiaire pour l'accrochage. Éventuellement, une cavité 34 est réalisée de sorte à recevoir la cale 25 lorsque celle-ci a été accrochée et vient s'appliquer sur la paroi périphérique de l'élément roulant 28. La cavité 34 peut disposer de formes et de dimensions équivalentes à celles de la cale 25. La cavité 34 est avantageusement placée au droit du crochet 32 pour recevoir la cale 25 immédiatement lorsqu'une rotation est entamée. De préférence, le crochet 32 est configuré pour s'insérer dans une zone située entre la face inférieure de la cale 25 et la face supérieure de la zone périphérique 2. Suivant une possibilité, la tige 31 est mobile de sorte à opérer un mouvement de rétractation plaquant la cale 25 (ou directement la bordure du film 15) contre l'élément roulant 28 et préférentiellement dans la cavité 34. On peut prévoir une pluralité de tiges 31 et de crochets 32 s'étendant, de préférence régulièrement, suivant la direction longitudinale de l'élément roulant 28. On peut aussi prévoir un élément continu de sorte que la tige 31 et le crochet 32 forment deux ailes d'un profilé. La cavité 34 s'étend par ailleurs de préférence suivant la direction longitudinale de l'élément roulant 28.

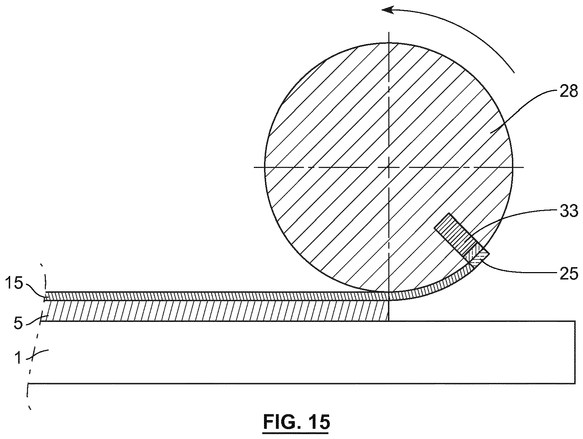

Dans la situation de la figure 15, on profite d'un effet magnétique. La cale 25 est de nature métallique, de préférence ferrique, et l'élément roulant 28 comporte une portion d'attraction 33, par exemple sous la forme d'un insert s'étendant vers l'intérieur du corps de l'élément 28 et avantageusement affleurant au niveau de sa surface périphérique. Cet insert dispose de propriétés magnétiques configurées pour attirer la cale 25. Alternativement, l'insert peut être métallique et la cale être magnétique. En outre, les deux éléments peuvent être magnétiques et de polarités aptes à s'attirer. On peut prévoir une pluralité de portions 33 espacées, de préférence régulièrement, suivant la direction longitudinale de l'élément roulant 28. On peut aussi prévoir une portion 33 s'étendant sur une large partie, de préférence plus de 50 % est avantageusement 100 %, de la longueur de l'élément roulant 28.

De manière alternative ou complémentaire à l'attraction magnétique, il est aussi possible de jouer sur d'autres effets d'application du film 15 sur l'élément roulant 28. Par exemple, un collage de la bordure du film 15 sur l'élément roulant 28 peut permettre de la fixer en position et d'entraîner l'enroulement lors de la rotation suivant le sens 29.

Toute disposition alternative à celles précédemment décrites pour permettre de solidariser l'extrémité du film 15 à l'élément roulant 28 est possible. En outre, les solutions décrites peuvent être combinées suivant toutes associations.

On notera qu'un avantage de ces réalisations est que les contraintes de traction peuvent être réparties au niveau du substrat fin 5. Ainsi, le procédé de déclampage est facilité et les propriétés de flexibilité du substrat 5 et du film 15 sont préservées. L'adjectif « roulant » est utilisé du fait de la capacité de rotation propre de l'élément 28. Il n'est cependant pas absolument nécessaire que l'élément 28 se déplace suivant un plan parallèle au substrat et qu'il exerce un appui, ne serait-ce que par gravité, sur la surface supérieure du film 15 encore au contact du substrat 5.

Après avoir procédé à la séparation du substrat 5 relativement au support 1, une étape possible concerne en effet la séparation des composants en éléments unitaires. Il peut s'agir par exemple des méthodes de découpe de l'état de l'art adaptées aux matériaux verres fragiles comme la découpe mécanique à scie ou encore la découpe laser (laser CO2, laser YAG, laser femto seconde ou laser excimer).

Selon un mode de réalisation préférentiel, on réalise, avant formation du film 15, des zones ruptables 24 comme en figure 10 au niveau desquelles le substrat 5 est plus fragile qu'ailleurs. Il peut s'agir de zones d'épaisseur moindre. Les zones 24 forment de préférence un maillage entourant individuellement les composants. Pour du verre par exemple, un traçage est effectué par filamentation laser engendrant des fissures médianes sur une profondeur de 20 µm du verre. La définition des traits de découpe est fixée par les dimensions des composants. Cette étape est suivie par un procédé de rupture avant expansion du film 15 pour espacer les composants. Les composants se trouvent ainsi libres les uns des autres mais au contact du film 15.

Suivant un mode de réalisation, une possibilité est offerte pour séparer facilement des composants formés sur le substrat 5. La traction opérée sur le film lors de la séparation peut, dans ce cas, participer à cette étape d'individualisation des composants. Suivant une possibilité de mise en oeuvre, on effectue comme précédemment les opérations de traçage des chemins de découpe du substrat 5 de préférence préalablement à la réalisation des couches actives des composants. Le résultat final reste celui de la figure 10, avant formation du film 15. Il est possible par exemple de positionner les chemins de découpe selon la taille des composants unitaires en utilisant la filamentation laser sur une profondeur contrôlée entre 10 et 20 µm du substrat 5. Dans ce cas, le procédé de rupture permet d'avoir l'ensemble des composants disposés sur le film 15 lors de l'étape de traction. Optionnellement, les composants disposés sur le substrat 5 peuvent être placés de manière rapprochée les uns des autres afin de réduire la surface de contact entre le film 15 et la deuxième face du substrat 5. Cette préconisation présente l'avantage de réduire la longueur de collage du film adhésif entre les composants, notamment au niveau des zones 24. Par la suite, il suffit de procéder à la découpe du film 15 pour individualiser les composants par des techniques de l'état de l'art (mécanique ou laser).

Il est envisageable de disposer le substrat 5 en retrait géométrique par rapport au bord du support au niveau de la marche 3. Il y a ainsi une double marche : la marche 3 et une marche entre une partie de la première face du support 1 et le bord du substrat 5, l'épaisseur du substrat 5 déterminant la hauteur de cette deuxième marche. Les autres étapes restent inchangées mais cette solution crée un deuxième espace vide sous le film 15. En effet, le film 15 doit accommoder lors du procédé de laminage la topographie créée par la double marche : la deuxième marche (par exemple de 100µm) est formée exclusivement par l'épaisseur du substrat 5 et la marche 3 est celle définissant la zone périphérique 2 du support 1.

A l'inverse, dans le cas de la figure 11, le substrat 5 est débordant par rapport au périmètre interne de la zone périphérique et de la marche 3. Il s'ensuit une modification de l'espace 21 vide qui ne sera pas au contact du film 15, ce qui peut être favorable à l'amorce de décohésion entre le film 15 et la zone périphérique 2.Selon une autre variante, le substrat peut déborder du support, au moins dans une zone périphérique de sorte qu'un bord du film débordant du substrat soit libre.

Un autre mode de réalisation visible en figure 12 consiste à former un support avec une base similaire au cas précédent, mais comprenant en outre une partie amovible formant une cale 25. La cale 25 produit la zone périphérique 2 au niveau d'une de ses faces, repérée 27, destinée à être au contact du film. La face 26 opposée est au contact du reste du support 1. Cette cale produit ainsi une zone modifiée du support 1 au niveau de laquelle l'adhérence du film est modifiée relativement à l'adhérence produite au niveau du substrat 5.

### REFERENCES

- 1.: Support
- 2.: Zone périphérique
- 3.: Marche
- 4.: Zone de solidarisation
- 5.: Substrat
- 6.: Zone de solidarisation
- 7.: Zone d'adhésion
- 8.: Deuxième face
- 9.: Empilement capacitif
- 10.: Première électrode
- 11.: Connecteur
- 12.: Deuxième électrode
- 13.: Connecteur
- 14.: Isolant
- 15.: Film
- 16.: Première couche
- 17.: Deuxième couche
- 18.: Premier accès
- 19.: Deuxième accès
- 20.: Bordure de film
- 21.: Espace
- 22.: Direction de traction
- 23.: Zone de désolidarisation
- 24.: Zone ruptable
- 25.: Cale
- 26.: Première face
- 27.: Deuxième face
- 28.: Elément roulant
- 29.: sens de rotation
- 30.: embouchure
- 31.: tige
- 32.: crochet
- 33.: portion d'attraction

## Revendications

1. Procédé de fabrication d'un dispositif électronique comprenant un substrat (5), le procédé comprenant une étape d'assemblage du substrat (5), par une zone de solidarisation (6) d'une première face du substrat (1), avec une zone de solidarisation (4) d'une première face d'un support (1), puis une étape de désolidarisation du substrat (5) relativement au support (1), **caractérisé en ce qu'**il comprend :
- la formation d'au moins un composant électronique à partir d'une deuxième face du substrat (5) opposée à la première face du substrat (5) au moins en partie après l'étape d'assemblage;
- la formation d'un film (15) sur le substrat (5), ledit film (15) étant configuré pour adhérer à une zone d'adhésion (7) de la deuxième face du substrat (5), la force d'adhésion entre le film (15) et la zone d'adhésion (7) de la deuxième face du substrat (5) étant choisie supérieure à la force de solidarisation entre la zone de solidarisation (4) du support (1) et la zone de solidarisation (6) de la première face du substrat (5), l'étape de formation d'au moins un composant étant opérée avant l'étape de formation du film (15), l'étape de formation du film (15) étant opérée après l'étape d'assemblage et étant configurée pour recouvrir le au moins un composant électronique;
- après l'étape de formation du film (15), une traction sur le film (15) avec une force de traction configurée pour vaincre la force de solidarisation, sans vaincre la force d'adhésion.

2. Procédé selon la revendication précédente, dans lequel la traction est opérée au moins en partie par traction exercée au niveau d'un bord du film (15).

3. Procédé selon l'une des revendications précédentes, dans lequel la formation du film (15) est configurée pour créer une portion de film (15) débordant de la deuxième face du substrat (5), et de préférence, la traction est opérée au moins en partie par traction sur la portion de film (15) débordant.

4. Procédé selon l'une des revendications précédentes, dans lequel on forme, sur la première face du support (1), une zone périphérique (2) adjacente à la zone de solidarisation (4), et dans lequel la formation du film (15) est configurée pour que le film (15) adhère sur la zone d'adhésion (7) de la deuxième face du substrat (5) et recouvre au moins une partie de la zone périphérique (2), la zone périphérique (2) étant de préférence formée de sorte à ceinturer la zone de solidarisation (4) de la première face du support (1).

5. Procédé selon la revendication précédente, dans lequel la zone périphérique (2) présente une énergie de surface inférieure à celle de la zone d'adhésion (7).

6. Procédé selon la revendication précédente, dans lequel on opère un traitement de surface d'au moins une partie de la zone périphérique (2) de sorte à ce qu'elle présente une énergie de surface inférieure à celle de la zone d'adhésion (7).

7. Procédé selon l'une des revendications 4 à 6, comprenant la formation d'au moins une marche entre la zone de solidarisation (4) de la première face du support (1) et la zone périphérique (2) de sorte à positionner la zone périphérique (2) en retrait de la zone de solidarisation de la première face du support (1), procédé dans lequel la formation du film (15) est de préférence configurée pour ménager au moins un espace (21) non rempli du matériau du film (15) au-dessus de la marche (3).

8. Procédé selon la revendication précédente, dans lequel la dimension en hauteur de la marche (3) ou de l'ensemble des marches, suivant l'épaisseur du support (1), est choisie supérieure ou égale à l'épaisseur du film (15).

9. Procédé selon l'une des deux revendications précédentes, dans lequel le substrat (5) est débordant de la marche (3) suivant un plan de la première face du substrat (1).

10. Procédé selon l'une des revendications 4 à 9, dans lequel le support (1) comprend une cale (25) en appui, par une première face (26), sur une première face d'une partie sous-jacente du support (1), au moins une partie de la zone périphérique (2) étant formée par une deuxième face de la cale (25), opposée à la première face (26) de la cale (25), et dans lequel la cale (25) est de préférence choisie avec une épaisseur égale à celle du substrat (5).

11. Procédé selon l'une des revendications précédentes, dans lequel la force de traction a au moins une composante non nulle suivant une dimension en épaisseur du substrat (5).

12. Procédé selon l'une des revendications précédentes, dans lequel la traction est opérée en plusieurs points du film (15).

13. Procédé selon la revendication précédente, dans lequel la traction est opérée par un élément roulant (28), dans lequel au moins une partie de bordure du film (15) est fixée à une surface périphérique de l'élément roulant (28), et dans lequel on opère ensuite une rotation (29) de l'élément roulant (28) configurée pour enrouler le film (15) sur la surface périphérique de l'élément roulant (28).

14. Procédé selon l'une des revendications précédentes, dans lequel le film (15) est formé par laminage.

15. Procédé selon l'une des revendications précédentes dans lequel le film (15) est configuré pour encapsuler la deuxième face du substrat (5).

16. Procédé selon l'une des revendications précédentes, dans lequel le film (15) comporte au moins une première couche (16) de film configurée pour adhérer au moins sur la zone d'adhésion (7) de la deuxième face du substrat (5), et au moins une deuxième couche (17) de film au-dessus de ladite première couche (16) de film, l'au moins une deuxième couche (17) de film comprenant au moins une couche étanche à l'atmosphère extérieure.

17. Procédé selon l'une des revendications précédentes, dans lequel on forme, dans le substrat, au moins une zone ruptable (24), plus fragile que le reste du substrat (5), la traction étant configurée pour rompre la zone ruptable (24).

18. Procédé selon la revendication précédente, dans lequel on forme une pluralité de composants électroniques, les composants étant séparés par des zones ruptables (24).

19. Procédé selon l'une des revendications précédentes, dans lequel au moins un composant électronique est un empilement capacitif (9) ou une batterie ou un composant électrochrome.

## Patentansprüche

1. Verfahren zum Herstellen einer elektronischen Vorrichtung mit einem Substrat (5), wobei das Verfahren einen Schritt des Zusammenfügens des Substrats (5) mit einem Verbindungsbereich (4) einer ersten Seite eines Trägers (1) über einen Verbindungsbereich (6) einer ersten Seite des Substrats (1), dann einen Schritt des Lösens des Substrats (5) von dem Träger (1) umfasst,
**dadurch gekennzeichnet, dass** es umfasst:
- Ausbilden zumindest eines elektronischen Bauteils ausgehend von einer zweiten Seite des Substrats (5), die der ersten Seite des Substrats (5) entgegengesetzt ist, zumindest teilweise nach dem Schritt des Zusammenfügens;
- Ausbilden einer Folie (15) an dem Substrat (5), wobei die Folie (15) dazu ausgelegt ist, an einem Haftbereich (7) der zweiten Seite des Substrats (5) anzuhaften, wobei die Haftkraft zwischen Folie (15) und Haftbereich (7) der zweiten Seite des Substrats (5) höher gewählt ist als die Verbindungskraft zwischen dem Verbindungsbereich (4) des Trägers (1) und dem Verbindungsbereich (6) der ersten Seite des Substrats (5), wobei der Schritt des Ausbildens von zumindest einem Bauteil vor dem Schritt des Ausbildens der Folie (15) erfolgt, wobei der Schritt des Ausbildens der Folie (15) nach dem Schritt des Zusammenfügens erfolgt und dazu ausgelegt ist, das zumindest eine elektronische Bauteil zu überdecken;
- nach dem Schritt des Ausbildens der Folie (15) ein Anziehen an der Folie (15) mit einer Zugkraft, die dazu ausgelegt ist, die Verbindungskraft zu überwinden, ohne dabei die Haftkraft zu überwinden.

2. Verfahren nach dem vorangehenden Anspruch, wobei das Anziehen zumindest teilweise durch Anziehen im Bereich eines Randes der Folie (15) erfolgt.

3. Verfahren nach einem der vorangehenden Ansprüche, wobei das Ausbilden der Folie (15) dazu ausgelegt ist, einen Folienabschnitt (15) zu schaffen, der von der zweiten Seite des Substrats (5) übersteht und das Anziehen vorzugsweise zumindest teilweise durch Anziehen an dem überstehenden Folienabschnitt (15) erfolgt.

4. Verfahren nach einem der vorangehenden Ansprüche, wobei an der ersten Seite des Trägers (1) ein Umfangsbereich (2) ausgebildet wird, der an den Verbindungsbereich (4) angrenzt, und wobei das Ausbilden der Folie (15) dazu ausgelegt ist, dass die Folie (15) am Haftbereich (7) der zweiten Seite des Substrats (5) anhaftet und zumindest einen Teil des Umfangsbereichs (2) überdeckt, wobei der Umfangsbereich (2) vorzugsweise so ausgebildet ist, dass er den Verbindungsbereich (4) der ersten Seite des Trägers (1) umschließt.

5. Verfahren nach dem vorangehenden Anspruch, wobei der Umfangsbereich (2) eine Oberflächenenergie aufweist, die geringer als die des Haftbereichs (7) ist.

6. Verfahren nach dem vorangehenden Anspruch, wobei eine Oberflächenbehandlung von zumindest einem Teil des Umfangsbereichs (2) erfolgt, so dass er eine Oberflächenenergie aufweist, die geringer als die des Haftbereichs (7) ist.

7. Verfahren nach einem der Ansprüche 4 bis 6, umfassend das Ausbilden zumindest einer Stufe zwischen dem Verbindungsbereich (4) der ersten Seite des Trägers (1) und dem Umfangsbereich (2), so dass der Umfangsbereich (2) bezüglich des Verbindungsbereichs der ersten Seite des Trägers (1) zurückgesetzt positioniert ist, wobei bei dem Verfahren das Ausbilden der Folie (15) vorzugsweise dazu ausgelegt ist, zumindest einen nicht mit dem Material der Folie (15) ausgefüllten Freiraum (21) über der Stufe (3) auszubilden.

8. Verfahren nach dem vorangehenden Anspruch, wobei die Abmessung in der Höhe der Stufe (3) oder der Gesamtheit an Stufen in Richtung der Dicke des Trägers (1) größer oder gleich der Dicke der Folie (15) gewählt ist.

9. Verfahren nach einem der beiden vorangehenden Ansprüche, wobei das Substrat (5) in einer Ebene der ersten Seite des Substrats (1) von der Stufe (3) übersteht.

10. Verfahren nach einem der Ansprüche 4 bis 9, wobei der Träger (1) einen Keil (25) enthält, der mit einer ersten Seite (26) in Anlage an einer ersten Seite eines Unterbauteils des Trägers (1) ist, wobei zumindest ein Teil des Umfangsbereichs (2) von einer zweiten Seite des Keils (25) gebildet wird, die der ersten Seite (26) des Keils (25) entgegengesetzt ist, und wobei der Keil (25) vorzugsweise mit einer Dicke gleich der des Substrats (5) gewählt ist.

11. Verfahren nach einem der vorangehenden Ansprüche, wobei die Zugkraft entlang einer Dickenabmessung des Substrats (5) zumindest eine Komponente ungleich null aufweist.

12. Verfahren nach einem der vorangehenden Ansprüche, wobei das Anziehen an mehreren Stellen der Folie (15) erfolgt.

13. Verfahren nach dem vorangehenden Anspruch, wobei das Anziehen über ein Rollelement (28) erfolgt, wobei zumindest ein Randabschnitt der Folie (15) an eine Umfangsfläche des Rollelements (28) befestigt ist, und wobei dann eine Rotation (29) des Rollelements (28) erfolgt, die dazu ausgelegt ist, die Folie (15) auf die Umfangsfläche des Rollelements (28) aufzuwickeln.

14. Verfahren nach einem der vorangehenden Ansprüche, wobei die Folie (15) durch Laminierung ausgebildet ist.

15. Verfahren nach einem der vorangehenden Ansprüche, wobei die Folie (15) dazu ausgelegt ist, die zweite Seite des Substrats (5) zu umkapseln.

16. Verfahren nach einem der vorangehenden Ansprüche, wobei die Folie (15) zumindest eine erste Folienlage (16) enthält, die dazu ausgelegt ist, zumindest an dem Haftbereich (7) der zweiten Seite des Substrats (5) anzuhaften, sowie zumindest eine zweite Folienlage (17) über der ersten Folienlage (16), wobei die zumindest eine zweite Folienlage (17) zumindest eine gegenüber der Außenatmosphäre dichte Lage enthält.

17. Verfahren nach einem der vorangehenden Ansprüche, wobei in dem Substrat zumindest ein Sollbruchbereich (24) ausgebildet wird, der brüchiger als das restliche Substrat (5) ist, wobei das Anziehen dazu ausgelegt ist, den Sollbruchbereich (24) zu brechen.

18. Verfahren nach dem vorangehenden Anspruch, wobei eine Mehrzahl von elektronischen Bauteilen ausgebildet wird, wobei die Bauteile durch die Sollbruchbereiche (24) getrennt sind.

19. Verfahren nach einem der vorangehenden Ansprüche, wobei zumindest ein elektronisches Bauteil eine kapazitive Stapelung (9) oder eine Batterie oder ein elektrochromes Bauteil ist.

## Claims

1. Method for manufacturing an electronic device comprising a substrate (5), wherein the method comprising a step of assembling the substrate (5), by a joining zone (6) of a first face of the substrate (1), with a joining zone (4) of a first face of a carrier (1), then a step of disjoining the substrate (5) relatively to the carrier (1), **characterized in that** it comprises:
- the forming of at least one electronic component from a second face of the substrate (5) opposite the first face of the substrate (5) at least partially after the step of assembling;
- the forming of a film (15) on the substrate (5), said film (15) being configured to adhere to an adhesion zone (7) of the second face of the substrate (5), the adhesive force between the film (15) and the adhesion zone (7) of the second face of the substrate (5) being chosen greater than the joining force between the joining zone (4) of the carrier (1) and the joining zone (6) of the first face of the substrate (5), with the step of forming at least one component being carried out before the step of forming the film (15), with the step of forming the film (15) being carried out after the step of assembling and being configured to cover the at least one electronic component;
- after the step of forming the film (15), a traction on the film (15) with a force of traction configured to overcome the joining force, without overcoming the adhesive force.

2. Method as claimed in the preceding claim, wherein the traction is carried out at least partially by traction exerted on an edge of the film (15).

3. Method according to one of the preceding claims, wherein the forming of the film (15) is configured to create a portion of film (15) overhanging the second face of the substrate (5), and preferably, the traction is carried out at least partially by traction on the portion of the overhanging film (15).

4. Method according to one of the preceding claims, wherein, on the first face of the carrier (1), a peripheral zone (2) is formed adjacent to the joining zone (4), and wherein the forming of the film (15) is configured so that the film (15) adheres on the adhesion zone (7) of the second face of the substrate (5) and covers at least one portion of the peripheral zone (2), the peripheral zone (2) being preferably formed in such a way as to girdle the joining zone (4) of the first face of the carrier (1).

5. Method as claimed in the preceding claim, wherein the peripheral zone (2) has a surface energy less than that of the adhesion zone (7).

6. Method as claimed in the preceding claim, wherein a surface treatment is carried out on at least one portion of the peripheral zone (2) in such a way that it has a surface energy less than that of the adhesion zone (7).

7. Method according to one of claims 4 to 6, comprising the forming of at least one step between the joining zone (4) of the first face of the carrier (1) and the peripheral zone (2) in such a way as to position the peripheral zone (2) set back from the joining zone of the first face of the carrier (1), method wherein the forming of the film (15) is preferably configured to arrange at least one space (21) not filled with the material of the film (15) above the step (3).

8. Method as claimed in the preceding claim, wherein the height dimension of the step (3) or of the set of steps, according to the thickness of the carrier (1), is chosen greater than or equal to the thickness of the film (15).

9. Method according to one of the two preceding claims, wherein the substrate (5) is overhanging the step (3) according to a plane of the first face of the substrate (1).

10. Method according to one of claims 4 to 9, wherein the carrier (1) comprises a shim (25) bearing, by a first face (26), on a first face of an underlying portion of the carrier (1), at least one portion of the peripheral zone (2) being formed by a second face of the shim (25), opposite the first face (26) of the shim (25), and wherein the shim (25) is preferably chosen with a thickness equal to that of the substrate (5).

11. Method according to one of the preceding claims, wherein the traction force has at least one non-zero component according to a thickness dimension of the substrate (5).

12. Method according to one of the preceding claims, wherein the traction is carried out at several points of the film (15).

13. Method as claimed in the preceding claim, wherein the traction is carried out by a rolling element (28), wherein at least one edge portion of the film (15) is fixed to a peripheral surface of the rolling element (28), and wherein a rotation (29) of the rolling element (28) is then carried out configured to wind the film (15) on the peripheral surface of the rolling element (28).

14. Method according to one of the preceding claims, wherein the film (15) is formed by laminating.

15. Method according to one of the preceding claims wherein the film (15) is configured to encapsulate the second face of the substrate (5).

16. Method according to one of the preceding claims, wherein the film (15) comprises at least one first layer (16) of film configured to adhere at least on the adhesion zone (7) of the second face of the substrate (5), and at least one second layer (17) of film above said first layer (16) of film, with the at least one second layer (17) of film comprising at least one layer sealed from the outside atmosphere.

17. Method according to one of the preceding claims, wherein, in the substrate, at least one breakable zone (24) is formed, more fragile than the rest of the substrate (5), with the traction being configured to break the breakable zone (24).

18. Method as claimed in the preceding claim, wherein a plurality of electronic components is formed, with the components being separated by breakable zones (24).

19. Method according to one of the preceding claims, wherein at least one electronic component is a capacitive stack (9) or a battery or an electrochromic component.
